Europäisches Patentamt

European Patent Office

Office européen des brevets

(19)

(11) Veröffentlichungsnummer: **0 075 712**
**B1**

(12)

# EUROPÄISCHE PATENTSCHRIFT

(45) Veröffentlichungstag der Patentschrift:
30.04.86

(21) Anmeldenummer: 82107493.7

(22) Anmeldetag: 17.08.82

(51) Int. Cl.⁴: **H 01 J 37/063**

(54) Elektronenoptisches System zur Erzeugung eines Elektronen-Formstrahl mit variablem Strahlquerschnitt, insbesondere zur Erzeugung von Mikrostrukturen.

(30) Priorität: 30.09.81 DE 3138896

(43) Veröffentlichungstag der Anmeldung:
06.04.83 Patentblatt 83/14

(45) Bekanntmachung des Hinweises auf die Patenterteilung:
30.04.86 Patentblatt 86/18

(84) Benannte Vertragsstaaten:
DE FR GB NL

(56) Entgegenhaltungen:
EP - A - 0 002 409
US - A - 4 163 155

IEEE TRANSACTIONS ON ELECTRON DEVICES; Vol. ED-26, No. 4, April 1979, New York Hans C. PFEIFFER "Recent Advances in Electron-Beam Lithography for the High-Volume Production of VLSI Devices", Seiten 663-673
IBM JOURNAL OF RESEARCH AND DEVELOPMENT, Vol. 21, No. 6, November 1977; New York, MAUER et al. "Electron Optics of An Electron-Beam Lithographic System", Seiten 514-521

(73) Patentinhaber: Siemens Aktiengesellschaft, Berlin und München Wittelsbacherplatz 2, D-8000 München 2 (DE)

(72) Erfinder: Lischke, Burkhard, Prof.Dr., In der Heuluss 13, D-8000 München 83 (DE)
Erfinder: Froslen, Jürgen, Dr., An der Ottosäule 18, D-8012 Ottobrunn (DE)
Erfinder: Plies, Erich, Dr., Deisenhofenerstrasse 79c, D-8000 München 90 (DE)
Erfinder: Anger, Klaus, Dipl.-Ing., Putzbrunnerstrasse 123, D-8000 München 83 (DE)

## Beschreibung

Die Erfindung betrifft ein elektronenoptisches System nach dem Oberbegriff des Anspruchs 1.

Zur Strukturerzeugung auf Halbleitern werden in zunehmendem Maße Elektronenschreiber eingesetzt, bei denen mit Hilfe einer feinen Sonde ein Resist bestrahlt und dadurch ein Strukturmuster, z. B. ein Schaltungsmuster, erzeugt wird. Die kleiner werdenden Strukturabmessungen verlangen eine kleine Elektronensonde mit besserer Kantenschärfe bei hohem Sondenstrom. Durch Wechselwirkung der Elektronen im Elektronenstrahl wird aber ihre Energie und Richtung geändert (Boersch-Effekt), was bei wachsendem Sondenstrom zu einer Verschlechterung der Kantenschärfe führt. Auch Elektronenstrahl-Meßgeräte verlagen eine kleine Elektronensonde bei hohem Sondenstrom.

Aus IEEE Trans. on El. Dev., Vol. ED 26, No. 6, April 1979, S.663-674 ist ein elektronenoptisches System gemäß dem Oberbegriff des Anspruchs 1 bekannt. Bei diesem bekannten elektronenoptischen System wird ein Formstrahl mit variablem Querschnitt, der sich an die zu erzeugende Mikrostruktur anpassen läßt, dadurch erzeugt, daß ein Formstrahl mit vorgebbarem Strahlquerschnitt über eine strukturierende Blende bewegt wird. Der auf die strukturierende Blende auftreffende Formstrahl wird bei dem bekannten System durch elektronenoptische Abbildung einer Formstrahlblende auf die strukturierende Blende mit Hilfe einer Kondensorlinse erzeugt. Nachteilig hinsichtlich des Boersch-Effekts wirkt sich bei diesem bekannten elektronenoptischen System die große Länge des Strahlenganges von mehr als 1 m und die große Zahl von Strahlüberkreuzungspunkten von insgesamt fünf Strahlüberkreuzungspunkten aus, da die Länge des Strahlweges und die Orte, wo die Elektronen besonders dicht zusammenkommen, die unerwünschte, zum Boersch-Effekt führende Wechselwirkung der Elektronen untereinander fördert.

Um ein elektronenoptisches System den Erfordernissen von Elektronenstrahl-Meßgeräten anzupassen, muß dem beschriebenen Boersch-Effekt Rechnung getragen werden.

Der vorliegenden Erfindung liegt daher die Aufgabe zugrunde, ein elektronenoptisches System der eingangs genannten Art mit einem einfachen Aufbau anzugeben, welches gestattet, die Zahl der Strahlüberkreuzungspunkte herabzusetzen.

Diese Aufgabe wird erfindungsgemäß durch ein elektronenoptisches System der eingangs genannten Art gelöst, welches die kennzeichnenden Merkmale des Anspruchs 1 aufweist.

Ausgestaltungen und Vorteile der Erfindung sind in den Unteransprüchen, der Beschreibung und der Zeichnung dargestellt.

Ein erfindungsgemäßes elektronenoptisches System weist eine Leistungssteigerung gegenüber dem Stand der Technik auf, weil der Strahlengang verkürzt, und die Zahl der Strahlüberkreuzungen sowie die Anzahl der elektronenoptischen Komponenten wirksam verringert sind.

Die Erfindung ist in der Zeichnung dargestellt und wird im folgenden näher erläutert.

Fig. 1 zeigt einen Elektronenschreiber als erstes Ausführungsbeispiel der Erfindung.

Fig. 2 erläutert den Strahlengang beim Ausführungsbeispiel nach Fig. 1.

Fig. 3 zeigt einen weiteren Elektronenschreiber als Ausführungsbeispiel der Erfindung.

Fig. 4 erläutert den Strahlengang beim Ausführungsbeispiel nach Fig. 3.

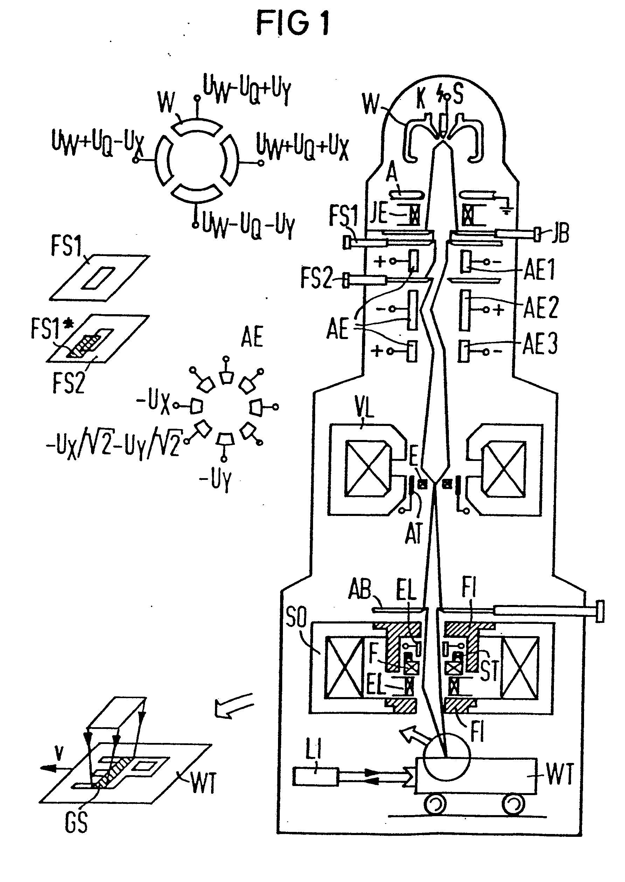

Fig 1 zeigt einen Elektronenschreiber als erstes Ausführungsbeispiel der Erfindung. Der Elektronenschreiber nach Fig. 1 zeichnet sich dadurch aus, daß a) die Formstrahlerzeugung mit Hilfe einer direkten Schattenabbildung ohne Zwischenschaltung einer elektronenoptischen Linse erfolgt, b) nur zwei magnetische Linsen VL, SO verwendet werden, c) die Zahl der Strahlüberkreuzungspunkte auf drei reduziert und d) die Länge des Strahlenganges auf ca. 60 cm gegenüber Ausführungsbeispielen nach dem Stand der Technik verkürzt ist.

Der variable Formstrahl wird dadurch erzeugt, daß mit Hilfe eines Strahlerzeugers eine erste Formstrahlblende FS1 von z. B. 50 × 200 $\mu m^2$ Abmessungen beleuchtet wird. Wegen der hohen Stromdichte des Primärelektronenstrahls und zur Vermeidung von Aufladungen bestehen die Justierblende JB der Druckstufe, die Formstrahl-Schlitzblenden FS1, FS2 und die Apertur- und Strahlaustastblende AB vorzugsweise aus Glaskohlenstoff oder einem hochschmelzenden Metall mit Graphitüberzug. Die durch die Formstrahl-Schlitzblende FS1 hindurchgelassene Intensität des Pimärelektronenstrahls beleuchtet eine zweite, strukturierende Schlitzblende FS2 und ihr Schattenbild FS1* kann auf dieser strukturierenden Schlitzblende FS2 mit Hilfe eines elektrischen Ablenksystems AE1 verschoben werden, so daß hinter der strukturierenden Schlitzblende FS2 Intensitäts-Rechtecke der gewünschten Form erzeugbar sind. Das elektrische Ablenksystem AE1 ist aus 8-Pol-Ablenkelementen AE gebildet. Die Kantenschärfe des so erzeugten Strahlquerschnitts hängt vom Abstand und Durchmesser der Elektronenquelle ab und kann den Erfordernissen entsprechend eingestellt werden. Der Formstrahlquerschnitt wird hinter der strukturierenden Schlitzblende FS2 durch zwei Ablenksysteme AE2, AE3 wieder auf die optische Achse zurückgelenkt und durch eine nachfolgende, magnetische Linse VL z. B. 50-fach in die Zwischenbildebene verkleinert abgebildet. Die beiden Ablenksysteme AE2, AE3 sind wiederum aus 8-Pol-Ablenkelementen AE gebildet. Die 8-Pol-Ablenkelemente AE der beiden Ablenksysteme AE1, AE3 sind in der Draufsicht von oben deckungsgleich angeordnet und haben dieselben Spannungen, nämlich bei einem beliebigen 8-Pol-Ablenkelement AE der Ablenksysteme AE1, AE3 beginnend mit $U_y$ und zyklisch fortfahrend mit

$$U_x / \sqrt{2} + U_y / \sqrt{2}; \; U_x; \; U_x / \sqrt{2} - U_x / \sqrt{2}; \; - U_y;$$

$$- U_x / \sqrt{2} - U_y / \sqrt{2}; \; - U_x; \; - U_x / \sqrt{2} + U_y / \sqrt{2}.$$

Die 8-Pol-Ablenkelemente AE des Ablenksystems AE2 sind deckungsgleich angeordnet mit den 8-Pol-Ablenkelementen AE der Ablenksysteme AE1, AE3. Die 8-Pol-Ablenkelemente AE des Ablenksystems AE2 weisen jedoch genau die entgegengesetzte Spannungspolarität zu den 8-Pol-Ablenkelementen AE der Ablenksysteme AE1, AE3 auf. Die 8-Pol-Ablenkelemente AE des Ablenksystems AE2 sind genau doppelt so lang wie die 8-Pol-Ablenkelemente AE der Ablenksysteme AE1, AE3, welche ihrerseits jeweils gleich lang sind.

In der Zwischenbildebene ist das Strahlaustastsystem AT und ein Quadrupol als Entzerrer E zur Verzeichnungskorrektur angeordnet. Mit Hilfe des Sondenobjektivs kann das Zwischenbild des Formstrahlquerschnitts ("Sonde") schließlich etwa 3-fach verkleinert auf das Target auf dem Wafertisch WT abegebildet werden. Die Linse des Sondenobjektivs SO enthält elektrischmagnetische Ablenksysteme, welche aus Ablenkelementen EL gebildet sind, eine dynamische Feinfokussierspule F mit kompensierter Bilddrehung und einen Stigmator ST.

Die Auftreffstelle der geformten Sonde GS auf das Target ist in der Fig. 1 in einem kreisförmigen Ausschnitt dargestellt. Das auf dem Wafertisch T angeordnete Target wird zusammen mit diesem Wafertisch WT mit einer Geschwindigkeit v bewegt, wobei diese Bewegung über ein Laserinterferometer LI gesteuert wird.

Das Linsenfeld des Sondenobjektivs SO ermöglicht es, daß zum einen die Bildfehler zusammen mit den Ablenksystemen, welche aus den Ablenkelementen EL gebildet sind, möglichst klein werden, und daß zum anderen das Feld am Ort des zu bearbeitenden Werkstückes auf dem Wafertisch WT möglichst klein ist. Hierzu weisen die Polzylinder der Linse des Sondenobjektivs SO eine entsprechende Form auf. Als Material dieser Polzylinder wird vorzugsweise Ferrit verwendet, so daß das magnetische Ablenksystem, welches aus Ablenkelementen EL bebildet ist, keine störenden Wirbelströme induziert.

Der Strahlerzeuger besteht aus einem $LaB_6$-Strahler K mit einer speziell geformten Fernfokus-Multipol-Wehnelt-Elektrode W. Eine geeignete Fernfokus-Multipol-Wehnelt-Elektrode W besteht beispielsweise aus vier Ablenkelementen eines 4-Pols mit den zyklischen Spannungen der 4-Pol-Ablenkelemente $U_w - U_Q + U_y$; $U_w + U_Q + U_x$; $U_w - U_Q - U_y$; $U_w + U_Q - U_x$. Durch eine entsprechende Versorgungsspannung S des Strahlers K wird der Cross-over des Primärelektronenstrahls hinter die Anode A verlegt, so daß kein Strahlüberkreuzungspunkt im Bereich niedriger Primärelektronen-Energie entsteht, wodurch die störende Wechselwirkung der Elektronen (BOersch-Effekt) verringert wird. Durch Zusatzspannungen $U_w$, $U_Q$ am Multipol-Wehnelt W kann der Primärelektronenstrahl auf die optische Achse justiert und die Intensität des Strahles auf der Formstrahl-Schlitzblende FS2 passend eingestellt werden.

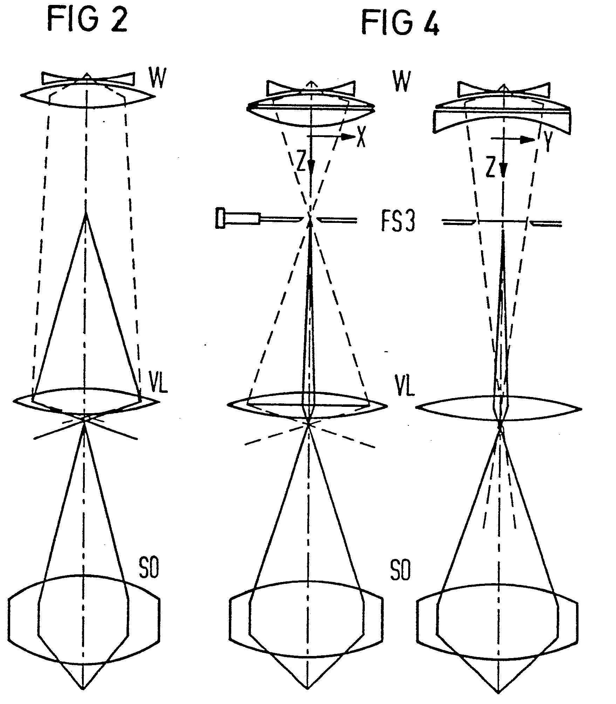

Fig. 2 erläutert den Strahlengang beim Ausführungsbeispiel der Erfindung nach Fig. 1. Der Elektronenstrahl wird von der Linse der Fernfokus-Multipol-Wehnelt—Elektrode auf die optische Achse justiert, fokussiert und in seiner Intensität geregelt. Der von den Schlitzblenden FSF1 und FS2 gebildete Formstrahlquerschnitt wird durch die magnetische Verkleinerungslinse VL in die Zwischenbildebene verkleinert abgebildet. Mit Hilfe des Sondenobjektivs SO wird schließlich das Zwischenbild des Formstrahlquerschnitts verkleinert und entsprechend abgelenkt auf das Target abgebildet.

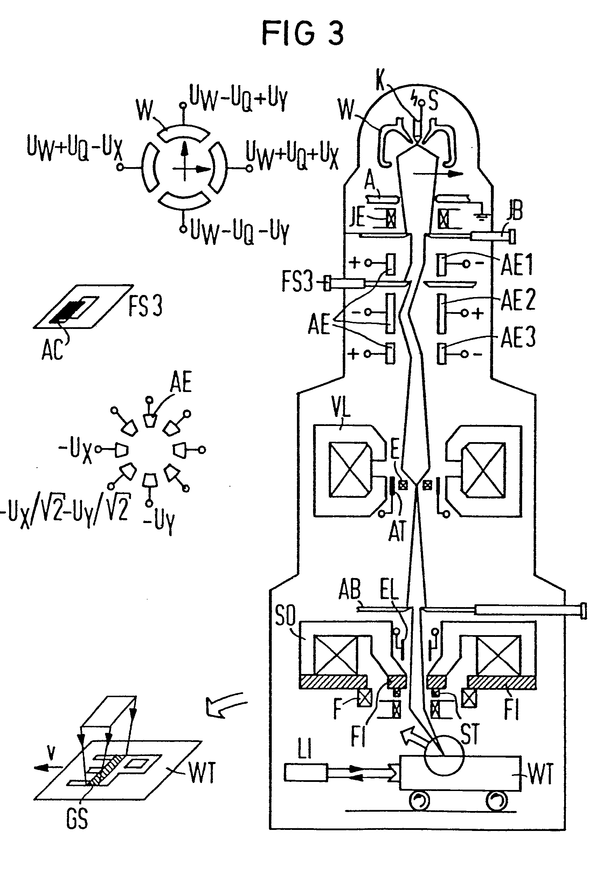

Fig. 3 zeigt einen weiteren Elektronenschreiber als Ausführungsbeispiel der Erfindung. Das Ausführungsbeispiel nach der Fig. 3 weist gegenüber dem Ausführungsbeispiel nach der Fig. 1. im wesentlichen zwei Änderungen auf, nämlich in der Erzeugung des auf die strukturierende Schlitzblende FS3 auftreffenden Formstrahls und im Sondenobjektiv SO. Die übrigen Bestandteile des Ausführungsbeispiels nach Fig. 3 sind gegenüber dem Ausführungsbeispiel nach Fig. 2 unverändert. Der Elektronenschreiber nach Fig. 3 zeigt die folgende Art der Formstrahlerzeugung: Mit Hilfe der Fernfokus-Multipol-Wehnelt-Elektrode W wird die Intensität des Primärelektronenstrahls zu einer Linie fokussiert, deren die strukturierende Blende durchsetzende Länge durch Verschieben des Elektronenstrahls über die strukturierende Schlitzblende FS3 mit Hilfe des Ablenksystems AE1 passend eingestellt werden kann. Durch Änderung der Wehnelt-Zusatzspannungen $U_w$, $U_Q$ läßt sich die von der Fernfokus-Multipol-Wehnelt-Elektrode W erzeugte Linie der Elektronenintensität jeweils so drehen, daß sie in Kombination mit der strukturierenden Schlitzblende FS3 für die Erzeugung des Schaltungsmusters auf dem Target in einer günstigen Richtung liegt. Mit dem in Fig. 3 gezeigten 4-Pol-Wehnelt W lßt sich die Linie der Elektronenintensität um 90° drehen. Beliebige Richtungen dieser Linie der Elektronenintensität lassen sich z. B. mit einem Oktupol-Wehnelt W erzeugen, wie er in Fig. 6 der europäischen Patentanmeldung EP-A-0 036 618 angegeben ist. Eine beliebige Richtung des astigmatischen Cross-overs AC läßt sich z. B. mit einem Oktupol-Wehnelt W erzielen, der aus zwei um 45° gegeneinander verdrehten Quadrupolelementen aufgebaut ist, die von unabhängig voneinander regelbaren Strömen durchflossen sind. Eine beliebige Richtung des astigmatischen Cross-overs AC läßt sich jedoch auch not mit weiteren Modifikationen von Hochstrom-Elektronenquellen erzielen, wie es in der genannten deutschen Patentanmeldung beschrieben ist. Die Offenbarung dieser genannten europäischen Patentanmeldung wird ausdrücklich in die vorliegende Offenbarung mit einbezogen.

Die zweite Änderung des Elektronenschreibers nach Fig. 3 gegenüber dem Elektronenschreiber nach Fig. 1 betrifft das Sondenobjektiv SO. Der Luftspalt der Linse des Sondenobjektivs SO ist dabei so angeordnet, daß das Linsenfeld im Außenraume des Linsenkörpers entsteht. Damit können die Hochfrequenz-Ablenksysteme, welche aus den Ablenkelementen EL gebildet sind, so angeordnet werden, daß keine durch Wirbelströme störende Materialien in der Nähe dieser Ablenkelemente EL sind.

Fig. 4 erläutert den Strahlengang bei dem Ausführungsbeispiel nach Fig. 3. Mit Hilfe der Fernfokus-Multipol-Wehnelt-Elektrode W wird die Elektronenintensität zu einer Linie auf die strukturierende Schlitzblende FS3 fokussiert. Die länge der die strukturierende Blende FS3 durchsetzenden Linie kann durch Verschieben der Elektronenintensität über die strukturierende Schlitzblende FS3 passend eingestellt werden.

Fig. 4 zeigt den Strahl einmal in der x-z-Ebene und einmal in der y-z-Ebene. Der astigmatische Cross-over AC (Kreuzungslinie) auf der strukturierenden Schlitzblende FS3 wird von der magnetischen Verkleinerungslinse VL in die Zwischenbildebene verkleinert abgebildet. Mit Hilfe des Sondenobjektivs SO wird das Zwischenbild des Formstrahlquerschnitts (astigmatischer Cross-over AC) verkleinert auf das Target abgebildet.

Mit einem erfindungsgemäßen Elektronenschreiber lassen sich eine Sondengröße von $1 \times 5\ \mu m$, ein Sondenstrom von 2 μAmpere, eine Kantenschärfe von 0,25 μm und ein Bildfeld ohne dynamische Korrektur von $1 \times 1\ mm^2$ erzielen.

Die Erfindung ist jedoch nicht auf Elektronenschreiber beschränkt. Sie läßt sich entsprechend auch auf Elektronenstrahl-Meßgeräte anwenden.

Die Erfindung ist nicht auf die angeführten Ausführungsbeispiele beschränkt. Zusammengefaßt lauten die wichtigsten Merkmale der besonderen Ausführungsarten der Erfindung: Erzeugung des auf die strukturierende Blende auftreffenden Formstrahls durch Schattenabbildung einer Formstrahlblende; Fernfokus-Multipol-Wehnelt-Elektrode W zur Justierung, Fokussierung und Intensitätsregelung; Feritpolzylinder FI im Sondenobjektiv (Ablenkobjektiv) SO; bzw. Sondenobjektiv (Ablenkobjektiv SO) mit außenliegendem Luftspalt.

Der durch die Anode A in z-Richtung austretende Strahl wird mit Hilfe des Justierelementes JE und einer Justierblende (JB) (Druckstufe) justiert.

## Patentansprüche

1. Elektronoptisches System zur Erzeugung eines Elektronen-Formstrahles mit variablem Strahlquerschnitt, insbesondere zur Herstellung von Mikrostrukturen, das Mittel zur Erzeugung des mit vorgebbarem Strahlquerschnitt (FS1*, AC) auf eine den Strahlquerschnitt strukturierende Blende (FS2; FS3) auftreffenden Formstrahles sowie Mittel (AE1) zur Ablenkung des Formstrahles über die Öffnung der strukturierenden Blende aufweist, um den Formstrahlenquerschnitt zu variieren, dadurch *gekennzeichnet,* daß die Mittel zur Erzeugung des auf die strukturierende Blende auftreffenden Formstrahles eine Fernfokus-Multipol-Wehnelt-Elektrode (W) aufweisen.

2. Elektronenoptisches System nach Anspruch 1, dadurch *gekennzeichnet,* daß die Mittel zur Erzeugung des auf die strukturierende Blende auftreffenden Formstrahles ferner eine Formstrahl-Blende (FS1) aufweisen, deren direkter Schatten den Strahlquerschnitt (FS1*) des Formstrahles auf der strukturierenden Blende (FS2) festlegt.

3. Elektronenoptisches System nach Anspruch 1 oder 2, *gekennzeichnet* durch einen Ferritpolzylinder (FI) im Sondenobjektiv (SO).

4. Elektronenoptisches System nach Anspruch 1 oder 2, *gekennzeichnet* durch ein Sondenobjektiv (SO) mit außenliegendem Luftspalt.

5. Elektronenoptisches System nach einem der Ansprüche 1 bis 4, *gekennzeichnet* durch zwei in Strahlrichtung hinter der strukturierenden Blende angeordnete magnetische Linsen (VL, SO).

6. Elektronenoptisches System nach einem der Ansprüche 1 bis 5, *gekennzeichnet* durch drei Strahlüberkreuzungspunkte zwischen der Fernfokus-Multipol-Wehnelt-Elektrode (W) und der Ebene, in der die Mikrostrukturen hergestellt werden.

7. Elektronenoptisches System nach Anspruch 1 bis 6, *gekennzeichnet* durch eine Länge des gesamten Strahlenganges von etwa 60 cm.

8. Elektronenoptisches System nach einem der Ansprüche 2 bis 7, dadurch *gekennzeichnet,* daß die Formstrahlblende (FS1) und die strukturierende Blende zwei hintereinander angeordnete Schlitzblenden sind und daß zwischen ihnen ausschließlich ein Ablenksystem (AE1) zur Erzeugung des Formstrahles angeordnet ist.

9. Elektronenoptisches System nach einem der Ansprüche 1 bis 7, dadurch *gekennzeichnet,* daß die Fernfokus-Multipol-Wehnelt-Elektrode (W) einen linienfokussierten Strahl erzeugt.

10. Elektronenoptisches System nach Anspruch 9, *gekennzeichnet* durch Mittel zum Drehen der Linie des linienfokussierten Strahles.

11. Elektronenoptisches System nach einem der Ansprüche 1 bis 10, *gekennzeichnet* durch Blenden (FS1,FS2; FS3; JB, AB) aus Glaskohlenstoff.

12. Elektronenoptisches System nach einem der Ansprüche 1 bis 10, *gekennzeichnet* durch Blenden (FS1,FS2; FS3; JB, AB) aus hochschmelzendem Metall mit Graphitüberzug.

13. Elektronenoptisches System nach einem der Ansprüche 1 bis 12, dadurch *gekennzeichnet,* daß ein Strahlaustastsystem (AT) in einem Zwischenbild des Formstrahlquerschnitts angeordnet ist.

14. Elektronenoptisches System nach einem der Ansprüche 1 bis 13, *gekennzeichnet* durch ein Sondenobjektiv (SO) mit Feinfokussierspule mit kompensierter Bilddrehung (F).

15. Elektronenoptisches System nach einem der Ansprüche 1 bis 14, dadurch *gekennzeichnet*, daß der in Strahlrichtung erste Strahlüberkreuzungspunkt hinter der Anode (A) liegt.

16. Elektronenoptisches System nach einem der Ansprüche 9 bis 15, *gekennzeichnet* durch Wehnelt-Zusatzspannungen zur Drehung der Linie des linienfokussierten Strahles.

17. Elektronenoptisches System nach einem der Ansprüche 1 bis 3 und 5 bis 16, mit einem Ferritpolzylinder (FI) im Sondenobjektiv (SO), dadurch *gekennzeichnet*, daß sowohl die quellseitige als auch die targetseitige Bohrung des Ferritpolzylinders (FI) kleiner sind als die radialen Abmessungen von Ablenkelementen (EL) bzw. einer dynamischen Fokussierspule (F), welche im Sondenobjektiv angeordnet sind.

## Claims

1. An electron-optical system for the production of a shaped electron beam with variable cross-section, in particular for the production of micro-structures, which has means for producing the shaped beam which hits a structuring diaphragm(FS2; FS3) with a predeterminable cross-section (FS1*; FS3), which diaphragm determines the cross-section of the beam, and means (AE1) for deflecting the shaped beam by means of the opening of the structuring diaphragm in order to vary the cross-section of the shaped beam, *characterised in that* the means for producing the shaped beam incident upon the structuring diaphragm has a tele-focus multipole Wehnelt electrode (W).

2. An electron-optical system as claimed in Claim 1, *characterised in that* the means for producing the shaped beam incident upon the structuring diaphragm includes a shaped beam diaphragm (FS1), whose direct shadow determines the cross-section (FS1*) of the shaped beam on the structuring diaphragm (FS2).

3. An electron-optical system as claimed in Claim 1 or 2, *characterised by* a ferrite pole cylinder (FI) in the probe lens (SO).

4. An electron-optical system as claimed in Claim 1 or 2, *characterised by* a probe lens (SO) with an external air gap.

5. An electron-optical system as claimed in one of Claims 1 to 4, *characterised by* two magnetic lenses (VL,SO) which are arranged behind the structuring diaphragm in the direction of beam travel.

6. An electron-optical system as claimed in one of Claims 1 to 5, *characterised by* three beam intersection points between the tele-focus multipole Wehnelt electrode (W) and the plane in which the micro-structures are produced.

7. An electron-optical system as claimed in one of Claims 1 to 6, *characterised by* an overall length of the beam path of approximately 60 cm.

8. An electron-optical system as claimed in one of Claims 2 to 7, *characterised in that* the shaped beam diaphragm (FS1) and the structuring diaphragm are two consecutively arranged slotted diaphragms, and that only a deflecting system (AE1) for producing the shaped beam is arranged between them.

9. An electron-optical system as claimed in one of Claims 1 to 7, *characterised in that* the tele-focus multipole Wehnelt electrode (W) produces a line-focussed beam.

10. An electron-optical system as claimed in Claim 9, *characterised by* means for rotating the line of the line-focussed beam.

11. An electron-optical system as claimed in one of Claims 1 to 10, *characterised by* diaphragms (FS1, FS2; FS3; JB, AB) made of glass carbon.

12. An electron-optical system as claimed in one of Claims 1 to 10, *characterised by* diaphragms (FS1, FS2; FS3; JB, AB) which consist of a high-melting metal with a graphite coating.

13. An electron-optical system as claimed in one of Claims 1 to 12, *characterised in that* a beam-blanking system (AT) is arranged in an intermediate image of the cross-section of the shaped beam.

14. An electron-optical system as claimed in one of Claims 1 to 13, *characterised by* a probe lens (SO) having a fine-focussing coil with a compensated image rotation (F).

15. An electron-optical system as claimed in one of Claims 1 to 14, *characterised in that* the first beam intersection point is arranged behind the anode (A) in the direction of beam travel.

16. An electron-optical system as claimed in one of Claims 9 to 15, *characterised by* Wehnelt additional voltages for rotating the line of the line-focussed beam.

17. An electron-optical system as claimed in one of Claims 1 to 3 and 5 to 16, with a ferrite pole cylinder (FI) in the probe lens (SO) *characterised in that* both the bores of the ferrite pole cylinder (FI) at the source end and those at the target end are smaller than the radial dimensions of deflecting elements (EL) and of a dynamic focussing coil (F) which are arranged in the probe lens.

## Revendications

1. Système optoélectronique pour produire un rayon d'électrons profilé à section transversale variable du rayon, en particulier pour la fabrication de microstructures, comportant des moyens pour produire le rayon profilé de section transversale (FS1*, AC) prédéterminée, incident sur le diaphragme (FS2; FS3) de structuration de la section transversale du rayon, ainsi que des moyens (AEI) pour dévier le rayon profilé sur l'ouverture du diaphragme de structuration en vue de faire varier la section transversale du rayon profilé, caractérisé par le fait que les moyens pour produire le rayon profilé incident sur le diaphragme de structuration comportent une électrode de Wehnelt (W) multipolaire et à grande distance focale.

2. Système optoélectronique selon la revendication 1, caractérisé par le fait que les moyens pour produire le rayon profilé incident sur diaphragme de structuration comportent, en outre, un diagramme de façonnage (FS1) dont l'ombre directe détermine la section transversale (FS1*) du rayon profilé sur le diaphragme de structuration.

3. Système optoélectronique selon la revendication 1 ou 2, caractérisé par un cylindre polaire (FI) en ferrrite dans l'objectif de sonde (SO).

4. Système optoélectronique selon la revendication 1 ou 2, caractérisé par un objectif de sonde (SO à entrefer situé à l'extérieur.

5. Système optoélectronique selon l'une des revendications 1 à 4, caractérisé par deux lentilles magnétiques (VL, SO) disposées en aval du diaphragme de structuration.

6. Système optoélectronique selon l'une des revendications 1 à 5, caractérisé par trois points de convergence entre l'électrode de Wehnelt multipolaire et à grande distance focale et le plan dans lequel les microstructures sont fabriquées.

7. Système optoélectronique selon les revendications 1 à 6, caractérisé par une longueur de la totalité de la trajectoire du rayon d'environ 60 cm.

8. Système optoélectronique selon l'une des revendications 2 à 7, caractérisé par le fait que le diaphragme de façonnage du rayon (FS1) et le diaphragme de structuration sont deux diaphragmes à fente disposés l'un derrière l'autre et qu'entre eux est exclusivement disposé un système de déviation (AE1) pour produire le rayon profilé.

9. Système optoélectronique selon l'une des revendications 1 à 7, caractérisé par le fait que l'électrode de Wehnelt (W) multipolaire et à grande distance focale, produit un rayon focalisé linéairement.

10. Système optoélectronique selon la revendication 9, caractérisé par des moyens pour faire tourner la ligne du rayon focalisé linéairement.

11. Système optoélectronique selon l'une des revendications 1 à 10, caractérisé par des diaphragmes (FS1, FS2; FS3; JB, AB) en polyacrylonitrile soumisà pyrolyse.

12. Système optoélectronique selon l'une des revendications 1 à 10, caractérisé par des diaphragmes (FS1, FS2; FS3; JB, AB) en un métal fusible à haute température et pourvus d'un revêtement de graphite.

13. Système optoélectronique selon l'une des revendications 1 à 12, caractérisé par le fait qu'un système de suppression du rayon (AT) est disposé dans une image intermédiaire de la section transversale du rayon profilé.

14. Système optoélectronique selon ll'une des revendications 1 à 13, caractérisé par un objectif de sonde (SO) avec une bobine de focalisation fine à rotation d'image compensée (F).

15. Système optoélectronique selon l'une des revendications 1 à 14, caractérisé par le fait que le premier point de convergence, dans le sens du rayon, se situe derrière l'anode (A).

16. Système optoélectronique selon l'une des revendications 9 à 15, caractérisé par une tension de Wehnelt supplémentaire pour la rotation de la ligne du rayon focalisé linéairement.

17. Système optoélectronique selon l'une des revendications 1 à 3 et 5 à 16, avec un cylindre polaire en ferrite (FI) dans l'objectif de sonde (SO), caractérisé par le fait que les perçages du cylindre polaire en ferrite (FI), situés aussi bien du côté de la source que du côté de la cible, sont inférieurs aux dimensions radiales des éléments de déviation (EL) ou d'une bobine de focalisation dynamique (F) qui sont disposés dans l'objectif de sonde.

# FIG 1

# FIG 2

# FIG 4

# FIG 3

$U_W - U_Q + U_Y$

$U_W + U_Q - U_X$        W        $U_W + U_Q + U_X$

$U_W - U_Q - U_Y$

FS 3

AC

AE

$-U_X$

$-U_X/\sqrt{2} - U_Y/\sqrt{2}$        $-U_Y$

K        S

W

A

JE        B

FS3        AE1

AE2

AE        AE3

VL

E

AT

AB   EL

SO

F        FI

FI        FI

LI        ST

WT        WT

v

WT

GS